Europäisches Patentamt

European Patent Office

Office européen des brevets

(11) Publication number: **0 225 957**
**A1**

# EUROPEAN PATENT APPLICATION

(21) Application number: 85830311.8

(51) Int. Cl.⁴: **H05K 13/04**

(22) Date of filing: 18.12.85

(43) Date of publication of application:
**24.06.87 Bulletin 87/26**

(84) Designated Contracting States:
**AT BE CH DE FR GB IT LI LU NL SE**

(71) Applicant: **ELCIT ELETTRONICA CIVILE S.p.A**
**Via Abegg 30**
**I-10050 San Antonino di Susa (Torino)(IT)**

(72) Inventor: **Gabutti, Lelio**
**Via Mascagni 3B**
**I-10055 Condove (Torino)(IT)**

(74) Representative: **Quinterno, Giuseppe et al**
**c/o Jacobacci-Casetta & Perani S.p.A. Via**
**Alfieri, 17**
**I-10121 Torino(IT)**

(54) Apparatus for positioning components on printed-circuit boards.

(57) The machine comprises:

-a support structure (1-3),

-a fixed mask (8) carried by the structure and having a plurality of apertures (9) for allowing the passage of a component (C),

-a plurality of reservoirs (5) for supplying the components, supported by the structure (1-3) above the fixed mask,

-a corresponding plurality of ducts (10a, 10b) connecting each aperture (9) of the fixed mask (8) to the outlet of a respective reservoir,

-controlled sequencing devices (7) interposed in the ducts (10a, 10b) between the reservoirs and the fixed mask and adapted, each time they are actuated, to allow a single component in each duct to fall towards the mask,

-a mask (13) beneath the fixed mask which is movable relative to the support structure and has a plurality of upwardly-open seats (14) for receiving respective components in a horizontal attitude; the movable mask being movable between a loading position in which it is disposed beneath the fixed mask to receive the components dropped by the sequencing means into the seats, and a withdrawn transfer position in which it can receive at least one printed circuit board (PCB) having drops of glue on its surface facing the mask in locations corresponding to the positions of the seats and

-transfer means (83;100-104) associated with a mov-
able mask for pushing the components from the seat (14) towards the printed circuit board (or boards resting on the movable mask in the withdrawn position of the mask.

FIG. 2

## Apparatus for positioning components on printed circuit boards

The present invention relates to a machine for positioning components on printed circuit boards. More particularly, the invention concerns a machine for positioning components of the so-called "MELF" type, that is components of a generally cylindrical form with end terminals, which are constituted by small cylinders or metal discs rather than wire rheophores. Such components may, for example, be resistors, capacitors, jumpers, etc.

These components are connected by direct welding of their ends to tracks of the printed circuits. For this purpose, the components of this type are positioned directly in contact with the conductive tracks and not on the other face of the printed circuit plate as is the case for components of ordinary type. Each component is held in position by a drop of polymeric glue previously applied at the location on the printed circuit board or plate on which the component is to be positioned.

Machines are known for positioning components of this type on printed circuit boards, in which the components to be positioned are positioned one at a time in succession according to a program controlled by a processor. Machines of this type have the advantage of allowing considerable operational flexibility and rapid adaptation to different types of board with different locations provided for the components. They have a relatively low positioning capacity, however, for example about 6000 pieces/hour.

Automatic machines are also known for positioning components of the type specified above, in which so-called positioning "masks" are used. In general, the term "mask" means a structure such as a plate having a plurality of seats or apertures formed in relative positions corresponding to the positions in which the components are to be positioned on a printed circuit plate. Each of these seats or apertures is adapted to receive or allow the passage of a respective component. In machines using positioning masks, a plurality of components passing through at least one such mask at each operative cycle is simultaneously positioned on one or more printed circuit boards in respective locations at which glue has previously been applied. The known machines of this type have a very high productivity which may reach, for example 60,000 components/hour. However, they are very complex and expensive and their acquisition is justified and hence economical only when extremely large production volumes are needed, which allow their costs to be absorbed.

The object of the present invention is to provide a semi-automatic machine for positioning components of the said type with the use of a positioning mask, which is simple and economical to manufacture so as to justify its acquisition and use even for relatively low production volumes, while ensuring a notably high production level.

This object is achieved according to the invention by a machine characterised in that it comprises:
-a support structure,
-a fixed mask carried by the structure and having a plurality of apertures for allowing the passage of respective components,
-a plurality of reservoirs for supplying components, supported by the structure above the fixed mask,
-a corresponding plurality of ducts connecting each aperture of the fixed mask to the outlet of a respective reservoir, for guiding the axial sliding of a succession of components towards the fixed mask,
-controlled sequencing means interposed in the ducts between the reservoirs and the fixed mask and adapted, each time they are actuated, to allow a single component in each duct to fall towards the mask,
-a mask beneath the fixed mask, which is movable relative to the support structure and has a plurality of upwardly open sets for receiving respective components in a horizontal attitude, the movable mask being movable between a loading position in which it is disposed beneath the fixed mask to receive the components dropped by the sequencing means through the fixed mask into the seats, and a withdrawn transfer position in which it can receive at least one printed circuit board having drops of glue on its surface facing the mask in locations corresponding to the positions of the seats, and
-transfer means associated with the mask for pushing the components from the seats towards the printed circuit board resting on the movable mask in the withdrawn position of the mask.

Further characteristics and advantages of the machine according to the invention will become apparent from the detailed description which follows with reference to the appended drawings, provided purely be way of non-limiting example, in which:

Figure 1 is a perspective view of a machine according to the invention,

Figure 2 is a section taken on the line II-II of Figure 1,

Figure 3 shows a detail of a machine according to the invention, indicated by the arrow III in Figure 2,

Figure 4 is an enlarged perspective view of a detail of the machine shown in Figure 2, indicated by the arrow IV in this Figure,

Figures 5 and 6 show a sequencing device in two different operative conditions, the sequencing device being indicated by the arrow IV in Figure 2,

Figure 7 shows the fixed mask, the movable mask, and its carriage according to the detail indicted by the arrow VII in Figure 2,

Figure 8 is a perspective view of a part of the movable mask,

Figure 9 shows a detail of Figure 7, indicated by the arrow IX in this Figure,

Figure 10 shows a detail of the machine according to the invention, in perspective,

Figure 11 shows the detail of the machine indicated by the arrow XI in Figure 2,

Figure 12 is a partially sectioned side view of a variant of the machine according to the invention,

Figure 13 is a perspective view of a removable module for the machine shown in Figure 12, and

Figure 14 is a perspective view of a second module which can be inserted in the machine of Figure 12 for the rapid discharge of the components.

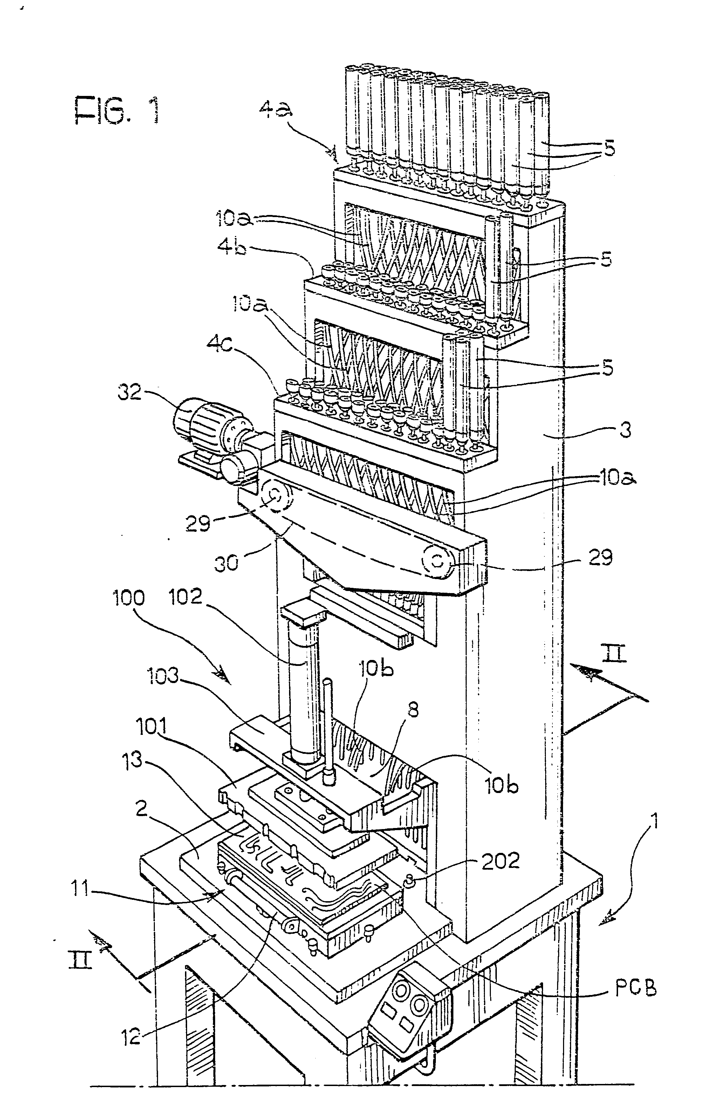

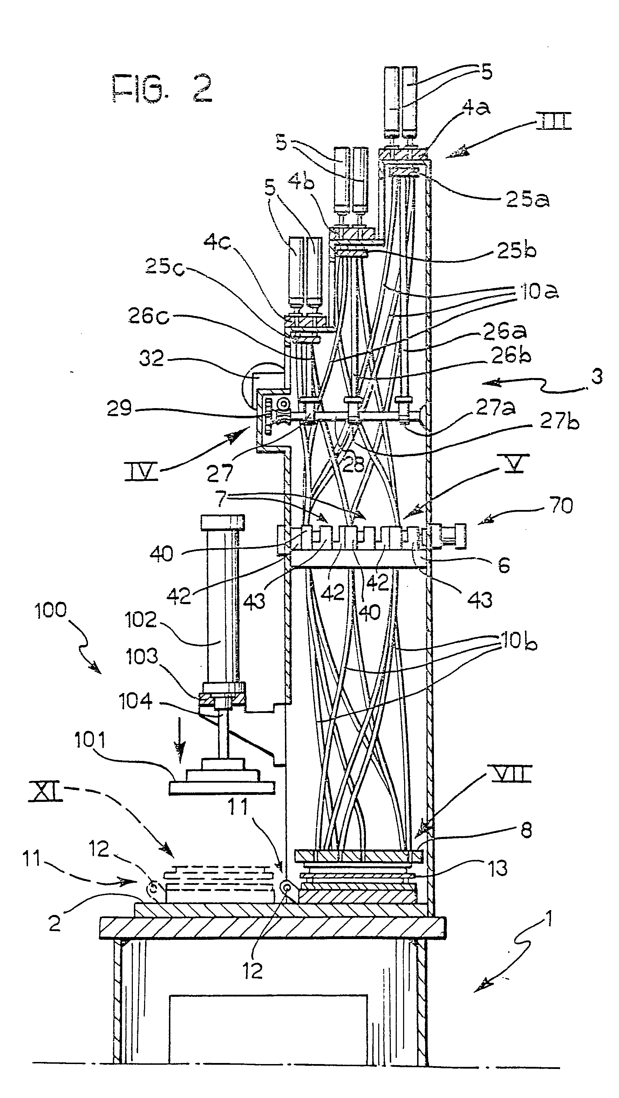

With reference to Figures 1 and 2, a machine according to the invention includes a support structure comprising a base 1 surmounted by a bench 2 and a frame 3. The upper part of the frame 3 forms three shelves 4a -4c at different heights, each supporting a respective plurality of component supply reservoirs disposed in two rows.

Sequencing devices 7, whose functions and structures will be described in detail below, are supported within the frame 3 (Figure 2) on a support plate 6.

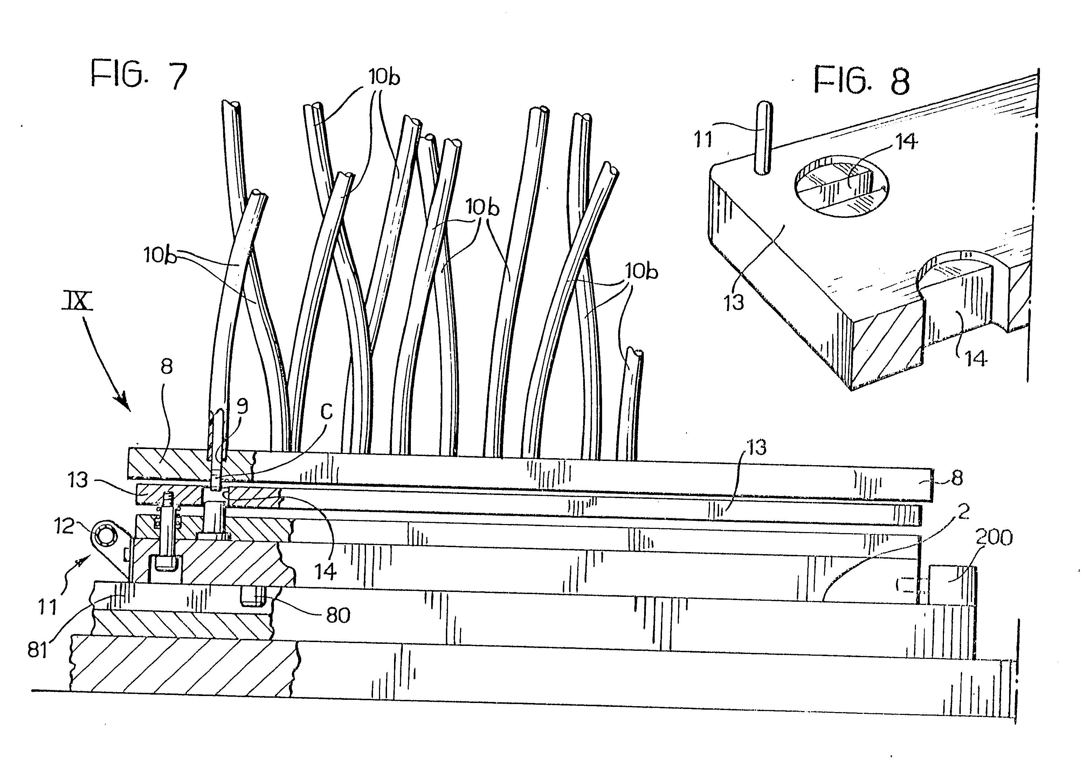

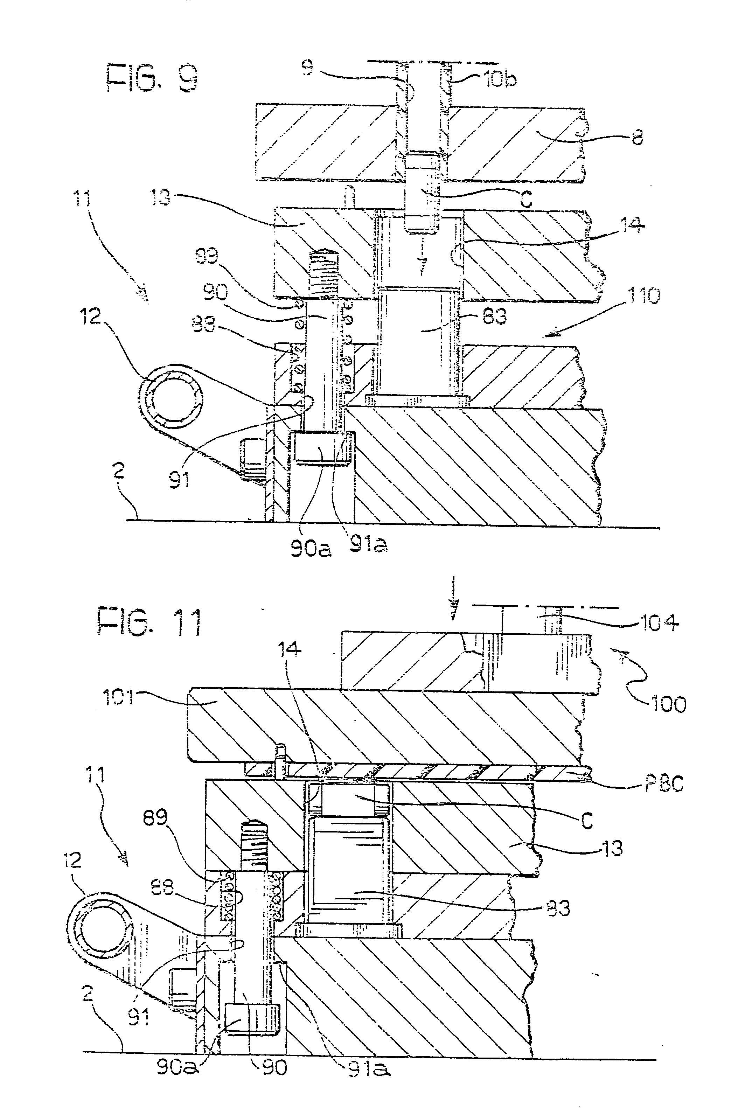

In the lower part of the frame 3, at a certain distance from the bench 2, a plate 8 is fixed in a horizontal position and has a plurality of vertical through-holes, indicated 9 in Figures 7 and 9, with diameters such as to allow the axial passage therethrough of a component, the holes being formed in relative positions corresponding to the locations at which the components are to be positioned on one or more printed circuit boards. The plate 8 thus acts as a fixed mask and will be called this below.

The reservoirs 5 are each connected to a respective aperture of the fixed mask 8 through respective ducts formed in two parts 10a, 10b, of which the first connects the reservoirs 5 to the sequencing devices 7 and the second connects the latter the first mask 8.

In operation, as will become apparent below, the reservoirs 5 supply a continuous flow of components to the sequencing devices 7 through the ducts 10a; the sequencing devices allow a single component in each duct 10b to fall towards the fixed mask 8 each time they are actuated.

A carriage is generally indicated 11 in Figures 1, 2, 7, 9 -11 and is movable on the bench 2 between a withdrawn position, shown in full outline in Figure 1 and in broken outline in Figure 2, and a condition of insertion in the frame 3, shown in Figure 2. In its inserted condition, the carriage 11 is disposed beneath the fixed mask 8. This carriage has a handle 12 by means of which an operator can move it between the two positions defined above.

On the carriage 11 is a plate 13 having a plurality of upwardly-open seats 14 (Figure 8) for receiving respective components in a horizontal attitude. The seats 14 are formed in relative positions corresponding to the locations at which the components are to be positioned on the printed circuit boards. The plate 13 will be termed the "movable positioning mask" below. When the carriage is in the inserted position shown in Figure 2, the seats 14 of the movable mask 13 face the apertures 9 in the fixed mask 8.

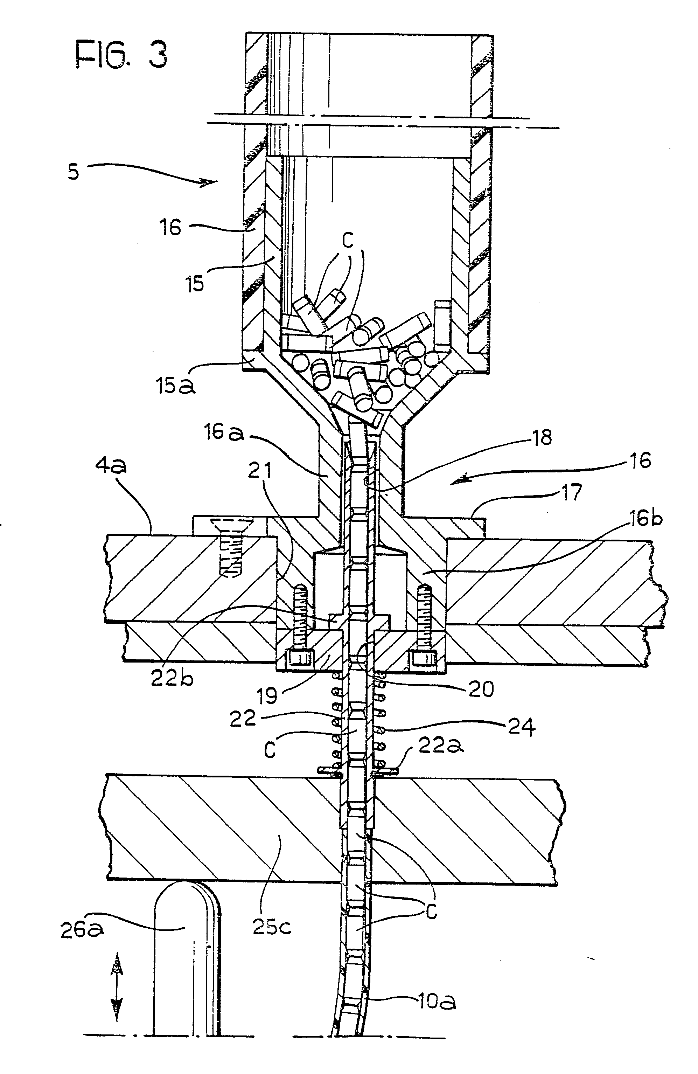

In the embodiment shown by way of example in the drawings, the reservoirs 5, as shown in Figure 3, each include a cup-shaped body 15 on which is fitted a tubular member 16 bearing on a radial flange 15a of the cup-shaped body. The bottom of the latter is funnel-or hopper-shaped and has a central extension 16 with a initial portion 16a of smaller internal and external diameters and a subsequent portion 16b of greater internal and external diameters joined at a radial flange 17. A passage 18 is defined within the tubular extension 16. To the lower end of the extension 16 is fixed a closure element 19 having a central aperture 20. The cup-shaped element 15 of each reservoir is connected to the respective shelf of the frame 3 by the insertion of the portion 16b of its extension into a corresponding aperture 21 formed in the shelf - (Figure 3), and the flange 17 acts as an element for bearing on and abutting the shelf. A hollow piston 22 is axially movable in the passage 18 within the tubular extension of each reservoir 5 and its lower end is connected to a duct 10a. In practice, this piston is constituted by a tube having an internal diameter slightly greater than that of the components C, and having a first flange 22a close to its lower end, and a flange 22b in its central zone within the portion 16b of the extension of the cup-shaped body 15.

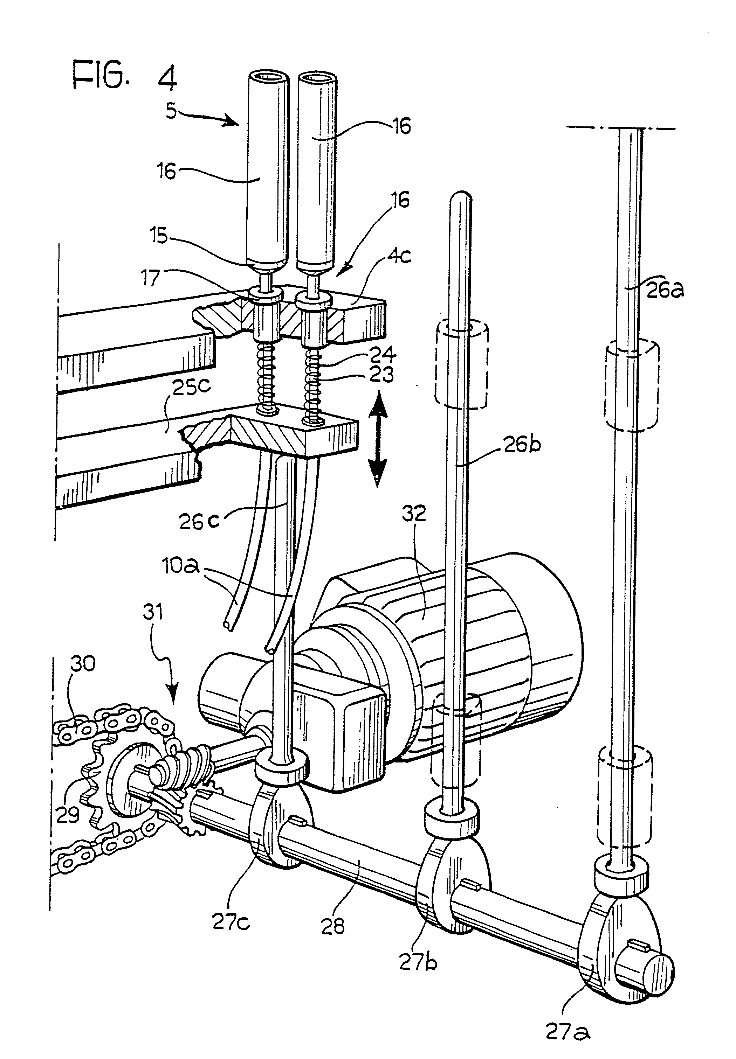

The flange 22b has a diameter greater than that of the aperture 20 of the closure element 19 and acts as a stop member for limiting the downward movement of the piston relative to the reservoir. Between the flange 22a and the closure element 19, and around the piston 22, is a helical spring 24 which urges the piston downwardly, with the shoulder 22b in contact with the closure element 19. The lower ends of the hollow pistons 22 relative to the reservoirs 5 associated with the same shelf of the frame 3 are fixed in apertures formed in respective cross members 25a -25c - (Figure 2) which are movable vertically. The ends of these cross members bear on vertically movable drive rods 26a -26c which bear on respective cam members 27a -27c mounted eccentrically on two transmission shafts 28 (of which only one is visible in Figures 2 and 4). Each shaft 28 has a respective gear wheel 29 at one end (Figures 1,2 and 4); the gear wheels are coupled by a chain 30. One of the two shafts 28 is coupled by a gear 31 (Figure 4) to the shaft of an electric motor 32 fixed outside the frame of the machine.

The activation of the motor 32 causes the rotation of the shafts 28 and the reciprocation of the drive rods 26 and hence of the hollow pistons 22 of the reservoirs 5.

These pistons, which preferably have upwardly-flared upper ends (Figure 3), are made to reciprocate between a lowered position in which they are beneath the bases of the cup-shaped bodies 15 of the respective reservoirs, and a raised position in which they extend within the hopper portion of each reservoir. The reciprocation of the hollow piston 22 of each reservoir 5 means that the components C piled in the cup-shaped body 15 gradually feed into the piston member and hence into the dust 10a connected thereto, as shown in Figure 3.

Conveniently, the ducts 10a have such a length that they can comply with the reciprocation of the hollow pistons 22 to which they are connected. The upper end of each duct 10a is thus made to reciprocate together with the respective hollow piston 22, and this reciprocation facilitates the downward sliding of the components C within the duct.

In operation, the activation of the motor 32 consequently creates a flow of the components C in the ducts 10a towards the sequencing devices 7, these components C descending in a lengthwise orientation.

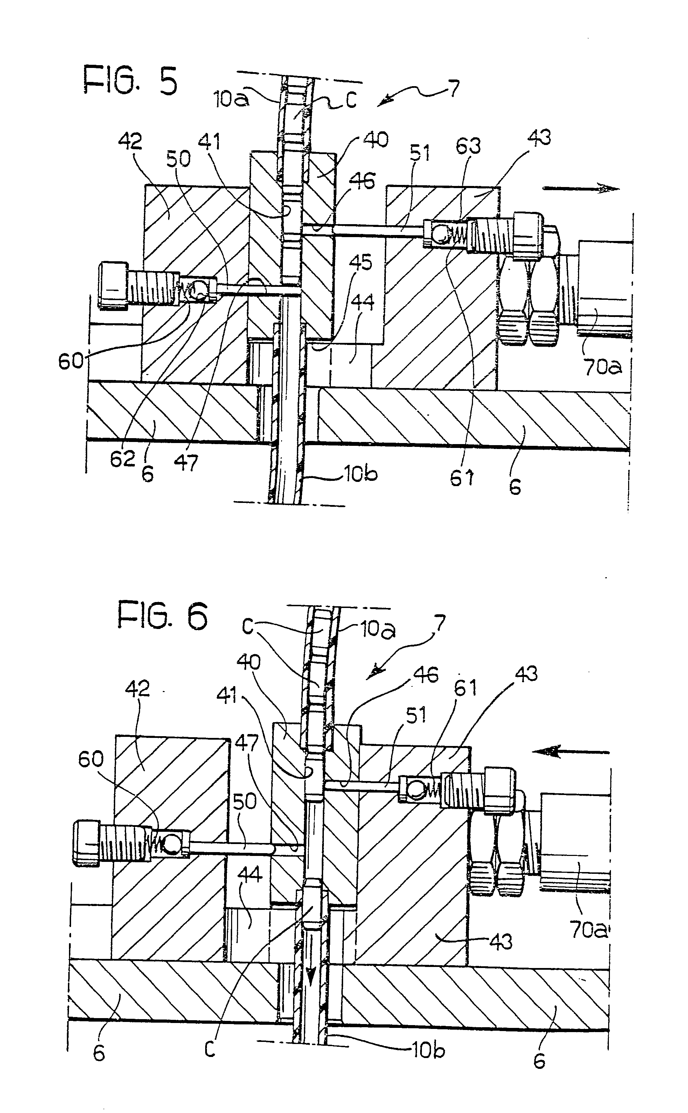

In the embodiment illustrated in the drawings, three arrays of sequencing devices are provided, each of which is identical to the others and is associated with an array of reservoirs 5 carried by the selfsame shelf of the frame 3. The structure and the operation of the sequencing devices 7 will be described now with reference to Figures 5 and 6.

Each array of sequencing devices includes a fixed cross member 40 fixed on top of the bracket or support plate 6 and having a plurality of vertical apertures 41 into the ends of which are inserted the lower ends of respective ducts 10a and the upper ends of corresponding ducts 10b. The inner diameters of the apertures 41 are slightly greater than the diameters of the components C. The movable part of each array of sequencing devices includes two cross members 42, 43 disposed on respective sides of the fixed cross member 40 and joined by connecting arms 44 which extend through corresponding apertures 45 formed in the lower part of the cross member 40. The space between the facing surfaces of the cross members 42 and 43 is greater than the thickness of the cross member 40 whereby the structure formed by the cross members 42 and 43 can move relative to the fixed cross member 40 between the extreme positions illustrated in Figures 5 and 6.

Each passage 41 in each cross member 40 is formed with an upper transverse radial aperture and a lower transverse radial aperture 46 and 47 respectively. These tranverse apertures open into the respective duct 41 at different levels separated by a distance less than twice the length of a component C. An array of retaining fingers 50 is mounted in each movable cross member 42, each being fitted into a respective transverse aperture 47 of the fixed cross member 40. Similarly, stop fingers 51 are mounted in each cross member 43 so as to face the fixed cross member 40, and each is fitted into a respective transverse aperture 46.

The fingers 50 and 51 are slidable in passages formed in the cross members carrying them and are resiliently urged towards the fixed cross member 40 by respective springs 60, 61 housed in cavities 62, 63 in these cross members.

In the embodiment illustrated in Figure 2, the cross member 42 associated with one fixed cross member 40 is connected to and movable fast with the movable cross member 43 associated with the adjacent fixed cross member 40; in other words, the cross member 42 and 43 associated with the three fixed cross members 40 are all movable fast with each other. For this purpose, a double-acting cylinder 70 is provided (Figure 2), of which only the piston rod 70a is visible in Figures 5 and 6.

In operation, when the movable structure 42 and 44 of each array of sequencing devices 7 is in the position shown in Figure 5, the fingers 50 obstruct the passages 41 in the fixed cross member 40, blocking the overlying column of components C. When the movable structures of the sequencing devices 7 move to the position illustrated in Figure 6, the fingers 50 free the passages 41 so as to allow the component C blocked just beforehand to fall, while the fingers 51 block the component C immediately above the one which falls. Thus, as was suggested previously, on each cyclic movement of the movable structure of the sequencing devices, a single component C in each of the ducts 10b is allowed to drop towards the fixed mask 8.

In use, an operator skilled with the machine inserts the carriage 11 carrying the fixed mask 13 into the frame 3. In this condition, if the sequencing devices 7 are moved from the condition of Figure 5 to the condition of Figure 6, a respective component C is made to fall into each seat 14 of the movable mask 13, as shown in Figure 9.

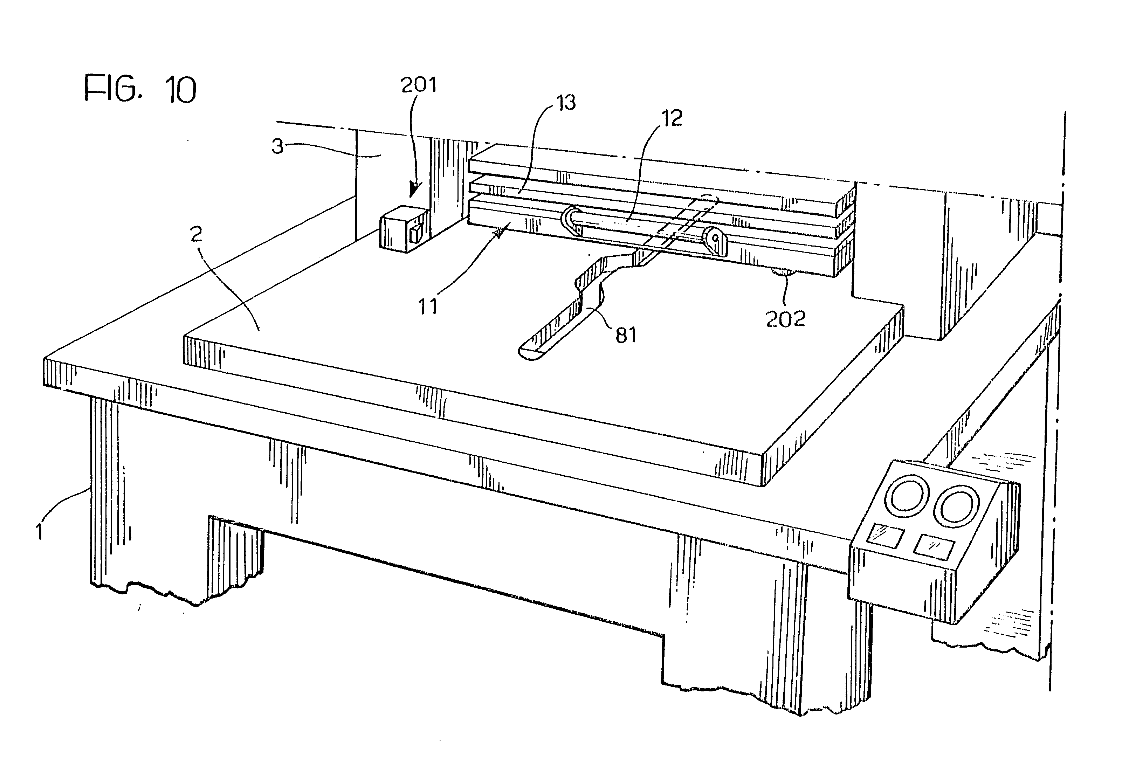

In practice, the seats 14 are constituted by through-holes having a cross-section substantially corresponding to the longitudinal section of a component C. Respective pusher members 83 fixed to the base 110 of the carriage 11 extend upwardly into these holes. In general, the component C dropped into each seat 14 by the sequencing devices may be disposed vertically or horizontally, or may be inclined. For the subsequent correct transfer of the components C from the movable mask 13 to one or more printed circuit boards, it is essential that all the components C be disposed horizontally in the seats 14. For this purpose, the operator withdraws the carriage 11 from the frame 3 by drawing the handle 12 towards himself. The carriage 12 has a lower projection 80 (Figure 7) which engages in a guide groove 81 (Figures 7 and 10) in the bench 2.

This groove is sinuous and conveniently has at least two sharp changes in direction.

The carriage 11, when withdrawn from the frame 3, is thus subjected to two sharp transverse oscillations, as a result of which all the components C carried by the movable mask 13 dispose themselves horizontally.

As shown in Figure 9, the movable mask 13 is resiliently supported on the carriage 11 in that it bears on the upper ends of helical springs 89 the lower ends of which bear on the bottom of corresponding recesses 18 in the base 110 of the carriage. To the underside of the movable mask 13 are fixed guide pins 90 which extend within the springs 89 and into suitable passages 91 in the bottom of the recesses 88 in the base of the carriage 11.

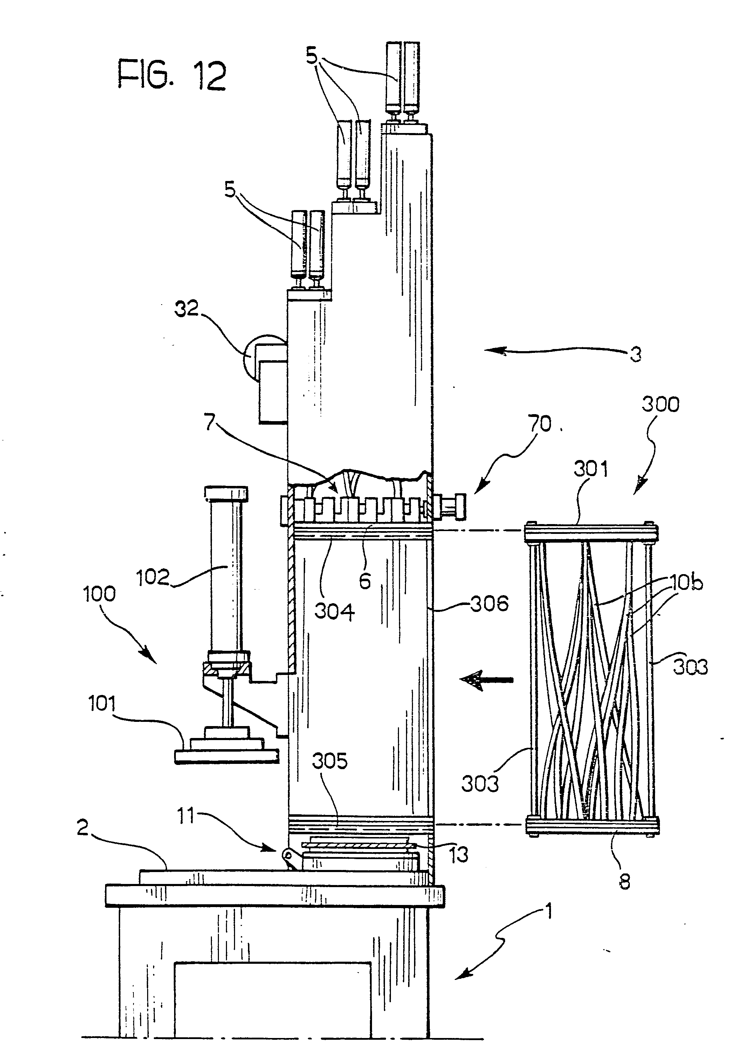

The lower ends of the pins 90 have respective heads 90a which cooperate with corresponding annular shoulders 91a formed in the passages 91. As is shown in Figures 9 and 11, the movable mask 13 is movable relative to the carriage 11 between a raised position (Figure 9) in which the pusher members 83 do not extend into the seats 14, and a lowered position in which the pusher members project into these seats.

The springs 89 bias the mask 13 into a normal raised position.

A presser device, generally indicated 100 in Figures 1, 2 and 11, is fixed to the front face of the frame 3 above the bench 2. This presser device comprises a double-acting cylinder 102 fixed, with its axis vertical, to a bracket 103 rigid with the frame 3. To the lower end of the rod 104 of the cylinder which faces the bench 2 of the machine is fixed a presser plate 101 which, in the withdrawn condition of the carriage 11, overlies the mask 13.

In operation, as stated above, the operator introduces the carriage 11 into the frame 3, then activates the sequencing devices 7 and causes the consequent fall of a single component C into each of the seats 14 of the movable mask 13. The operator then removes the carriage 11 manually from the frame 3, bringing the carriage beneath the presser plate 101. The operator then places a printed circuit board PCB on the movable mask 13 with its conductive tracks facing the mask 13, small drips of glue having previously been deposited on the board in the locations at which components C are to be deposited, the relative positions of the locations corresponding to the relative positions of the seats 14 of the mask 13. For correct positioning of the board PCB on the mask 13, pins 111 (Figure 8) may conveniently be fixed to the mask 13 for fitting into corresponding holes formed in the board.

Once the board is positioned on the mask 13, the operator activates the cylinder 102 through control means so as to cause the presser plate 101 to descend onto the board PCB, as shown in Figure 11. The presser plate 101 moves the movable mask 13 into the lowered position relative to the carriage 11 so that the components C deposited in the individual seats 14 are thrust by the pushers 83 against the board PCB, where they remain because of the glue previously applied thereto. The movement of the piston of the cylinder 102 is then reversed and the presser plate 101 rises again. The operator may at this point raise the board PCB with the components C glued to its lower face and transfer the board to an oven where the glue is polymerised.

Subsequently, the board so formed may be passed to a station for conventional soft soldering.

Naturally, the masks 8 and 13 may be arranged to achieve the positioning of the components on a plurality of printed circuit boards and not just on one as in the embodiment described above.

Clearly, for each new type of board, it will be necessary to provide a new fixed mask 8 and a corresponding new movable mask 13.

The machine may conveniently by provided with several safety devices. As shown in Figure 7, a microswitch 200 may be disposed on the bench 2 to detect when the carriage 11 reaches the inserted condition. The actuation of the sequencers 7 may be arranged to be enabled by this microswitch so as to avoid a "shower" of components when the carriage is not inserted.

As shown in Figure 10, a further microswitch 201 may be disposed on the bench 2 so as to be operated each time the carriage 11 is withdrawn: to advantage. the switching of the sequencers 7 from the condition shown in Figure 6 to that shown in Figure 5 may be arranged to be enabled by the microswitch 201. Furthermore, in order to avoid two or more components being loaded into the seats in the movable mask in the same cycle, a movable locking member 202 (Figure 1) may be activated by the microswitch 201 each time the carriage 11 is withdrawn from the frame of the machine. In these conditions, the member 202 projecting from the bench prevents the carriage 11 from being reinserted into the machine. This member may be lowered as a result of the activation of the cylinder 102 of the presser device 100.

The machine described above has a simple and robust structure and is thus highly reliable. The job of the operator may possibly be reduced solely to the insertion of the carriage 11 into the frame 3 and the activation of the cylinder 102. For this purpose, it suffices for a position sensor of known type (for example, a microswitch such as the switch 200 of Figure 7) to be disposed in the frame 3 so as to cause the automatic activation of the sequencer devices 7 and the fall of a single component C into each seat of the movable mask 13 when the carriage reaches the inserted position - (Figure 2). Once the carriage is withdrawn, the operator places the board (or boards) on the movable mask 13 and then activates the cylinder 102.

From tests carried out by the Applicants with the use of a semi-automatic prototype of this sort, it has been shown that it is possible to position about 10,000-15,000 components per hour. The productivity of the machine is thus very high although it has an extremely low manufacturing and running cost.

Figure 12 shows a variant of the machine described with reference to Figures 1 to 11. In Figure 12, the parts already described above have been given the same reference numerals.

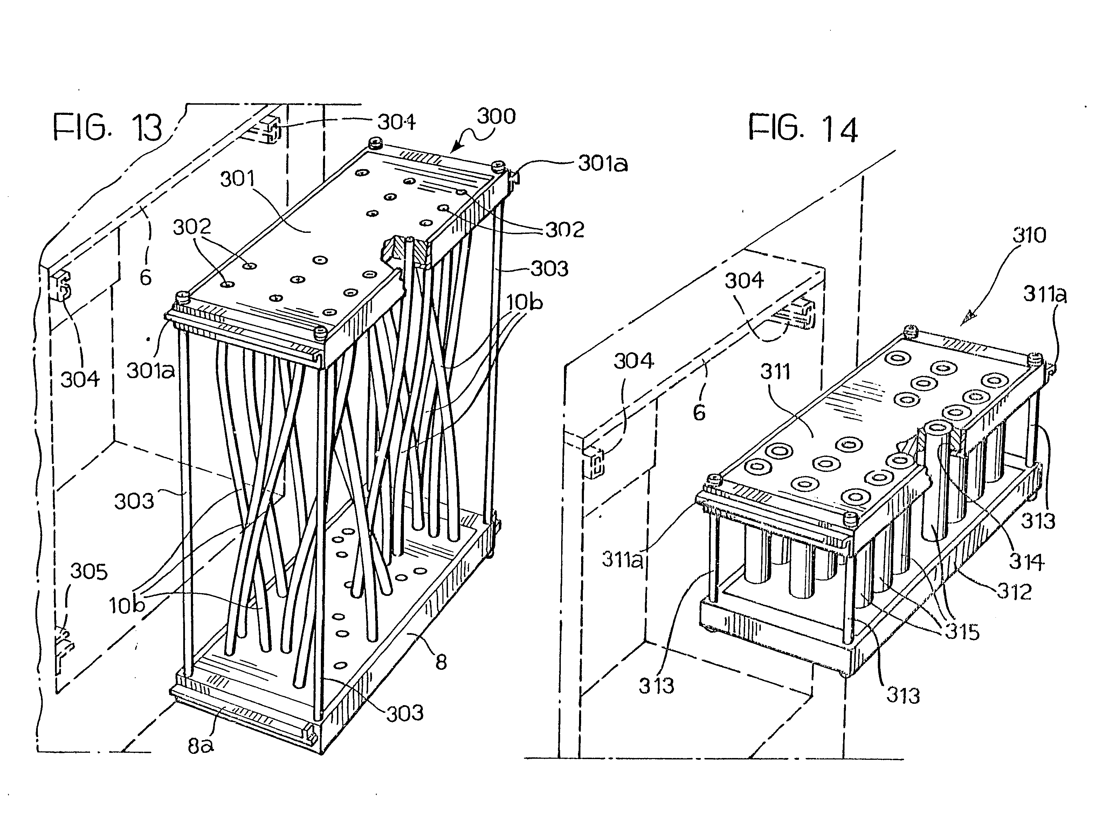

In the machine according to Figure 12, the fixed mask 8 constitutes the base of a module, generally indicated 300. This module includes an upper intermediate mask or plate 301 having apertures 302 for the passage of the components in positions exactly corresponding to the apertures of the support plate 6. The intermediate plate 302 is mechanically connected to the mask 8 by vertical tie rods 303. Moreover, the plate 301 and the mask 8 have respective projections 301a and 8a on opposite sides, which can engage corresponding guide channels 304, 305 fixed to the frame of the machine (Figures 12 and 13).

The upper part of the frame 2 of the machine has an aperture 306 (Figure 12) through which the module 300 can be inserted into or withdrawn from the machine.

A tube or duct 10b is fixed between each aperture 302 in the plate 301 and an aperture in the fixed mask 8.

The mode of operation of the machine according to Figure 12 is substantially identical to that of the machine of Figures 1 to 11: the components dropped by the sequencing devices 7 reach the fixed mask by passing through the apertures 302 in the upper plate 301 of the module 300 and the ducts 10b.

The machine of Figure 12, however; lends itself more readily to a change in working. In fact, when it is wished to change to the manufacture of a different type of printed circuit board, it suffices to replace the module of the machine with another arranged with a different appropriate fixed mask. Hence, it will suffice to provide as many modules as types of printed circuit board to be produced and to use the module corresponding to the board it is intended to produce each time.

When changing from the production of one type of board to another, it is usually necessary to empty the reservoirs 5 and the ducts 10a in order to change the MELF components. The emptying may be facilitated and hastened by the use of a discharge module such as that indicated 310 in Figure 14, which can be inserted into and removed from the machine. This discharge module includes two parallel rectangular plates 311, 312 joined at their corners by tie rods 313. The upper plate 311 has projections 311a on opposite sides for engaging the guides 304 of the machine. It also has a plurality of apertures 314 in a relative disposition corresponding to the relative disposition of the apertures of the plate 6 supporting the sequencers 7.

Preferably, however, the apertures 314 have a larger diameter compatible with the distance between these apertures, and cup-shaped cylindrical containers 315 are fitted therein for receiving the components discharged from the tubes 10a. In order to effect the emptying, the module 310 is inserted in the machine in place of the module 300 and the machine is then activated: the components fall in an orderly manner from the sequencers 7 into the containers 315 and may then be recovered easily. Once the emptying is finished, the new module of the type shown in Figure 13, corresponding to the type of board to be made, is inserted into the machine and, once the reservoirs 5 have been refilled, the working is restarted.

## Claims

1. Machine for positioning MELF-type components on printed circuit boards (PCB), in which, during each operating cycle, a plurality of components (C) is simultaneously positioned through at least one positioning mask (8,13) on one or more printed circuit boards (PCB) in respective locations at which glue has previously been applied, characterised in that it comprises:

-a support structure (1-3),

-a fixed mask (8) carried by the structure and having a plurality of apertures (9) for allowing the passage of respective components (C),

-a plurality of reservoirs (5) for supplying the components (C), supported by the structure (1-3) above the fixed mask (8),

-a corresponding plurality of ducts (10a, 10b) connecting each aperture (9) of the fixed mask (8) to the outlet of a respective reservoir (8), for guiding the axial sliding of a succession of components - (C) towards the fixed mask (8),

-controlled sequencing means (7) interposed in the ducts (10a, 10b) between the reservoirs (5) and the fixed mask (8) and adapted, each time they are actuated, to allow a single component (C) in each duct (10a,10b) to fall towards the mask (8),

-a mask (13) beneath the fixed mask (8) which is movable relative to the support structure (1-3) and has a plurality of upwardly-open seats (14) for receiving respective components (C) in a horizontal attitude; the movable mask (13) being movable between a loading position in which it is disposed beneath the fixed mask (8) to receive the components (C) dropped by the sequencing means (7) through the fixed mask (7) into the seats (14), and a withdrawn transfer position in which it can receive at least one printed circuit board (PCB) having drops of glue on its surface facing the mask (13) in locations corresponding to the positions of the seats (14), and

-transfer means (83;100-104) associated with a movable mask (13) for pushing the components - (C) from the seat (14) towards the printed circuit board (PCB) resting on the movable mask (13) in the withdrawn position of the mask (13).

2. Machine according to Claim 1, characterised in that each supply reservoir (5) comprises:

a container (15,16) fixed to the support structure (1-3) for receiving a plurality of loose components (C), the container (15, 16) having an aperture (18) in its bottom in which there is mounted an axially hollow piston (22) through which the components (C) can pass, and which is movable between a lowered position in which it is beneath the bottom of the container and a raised position in which it extends within the container (15, 16); the lower end of the piston (22) being connected to a respective duct - (10a) of the plurality of ducts; and

drive means (24-32) for cyclically reciprocating the piston (22) between the lowered and raised positions.

3. Machine according to Claim 2, characterised in that the drive means (24-32) are arranged to cause the simultaneous reciprocation of the hollow pistons (22) of all the reservoirs (5).

4. Machine according to Claim 2 or Claim 3, characterised in that the hollow pistons (22) of the reservoirs (5) are fixed to at last one support member (25) which is movable vertically relative to the support structure (1-3), and the drive means include an electric motor (32) and a cam transmission mechanism (26-30) between the motor (32) and said at least one support member (25).

5. Machine according to any one of Claims 2 to 4, characterised in that at least the portion (10a) of each duct (10a, 10b) between the respective reservoir (5) and the sequencing means (7) is flexible.

6. Machine according to any one of the preceding claims, characterised in that the sequencing means (7) include at least one body (40) which is fixed to the support structure (1-3) and in which there are formed a plurality of vertical passages - (41) each connected to one of the reservoirs (5) and to the fixed mask (8) by means of the ducts - (10a, 10b); the body (40) being formed, for each passage (41), with an upper transverse aperture - (46) and a lower transverse aperture (47) opening into the passage (41) at levels separated by a distance less than twice the length of a component (C); a retaining finger (51) and a stop finger (50) are mounted in the upper aperture (46) and the lower aperture (47), respectively, for interacting with two adjacent components (C) in the passage - (41); the fingers being slidable between a respective withdrawn position in which they allow the free descent of the components (C) in the passage (41), and an inserted condition in which they can block and retain a component facing them; operating means (70) being provided for simultaneously moving all the retaining fingers (51) between the withdrawn position and the inserted one and, at the same time, all the stop fingers (50) between the inserted condition and the withdrawn position, so that, in use, each time the retaining fingers (50) move into their withdrawn position, a single component is allowed to fall in each of the ducts (10b) towards the fixed mask (8).

7. Machine according to Claim 6, characterised in that the upper and lower transverse apertures - (46, 47) of the body (40) are parallel to each other and formed in opposite sides of the wall of the respective passages (41) of the body (40).

8. Machine according to Claim 7, characterised in that the sequencing means (7) include a structure (42-44) which is movable relative to the fixed body (40) and comprises first and second members (43, 42) located on opposite sides of the fixed body (40) in the direction of the transverse apertures (46, 47) and spaced from each other; the first and second members (43, 42) carrying the stop fingers and the retaining fingers (51, 50) respectively; drive means (70) being provided for moving the structure (42-44) relative to the fixed body (40) so that the approach of a member (42) or (43) of the structure towards the fixed body (40) results in the movement away of the other member (43) or (42) and vice versa.

9. Machine according to Claim 8, characterised in that the retaining fingers (51) and stop fingers - (52) respectively are movable in respective parallel recesses formed in the members (42, 43) of the movable structure (42-44) of the sequencing means (7); resilient means (61, 60) being provided for urging the fingers (51, 50) towards the central fixed body (40).

10. Machine according to Claim 8 or Claim 9, characterised in that the drive means include a double-acting cylinder (70).

11. Machine according to any one of the preceding claims, characterised in that it includes a carriage (11) movable along guide means (81) supported by the support structure (1-3); the carriage - (11) having a base structure (110) on which the movable mask (13) rests with the interposition of suspension means (89); the movable mask (13) being movable relative to the base structure (110) between a normal raised loading position for the components (C) and a lowered position; and in that the transfer means (83) are supported by the base structure (110) of the carriage (11) and can thrust the components (C) carried by the movable mask - (13) towards the overlying printed circuit board - (PCB) as a result of the passage of the mask (13) from the raised position to the lowered position.

12. Machine according to Claim 11, characterised in that the movable mask (13) is constituted by a plate and the seats (14) are constituted by upwardly-open holes having a cross-section substantially corresponding to the longitudinal profile of a component (C).

13. Machine according to Claim 12, characterised in that the guide means (81) are arranged to impart at least one sharp change of direction to the carriage (11) when the movable mask (13) is moved from the loading position to the transfer position, so as to place the component (C) housed in the seat (14) of the movable mask (13) in a horizontal attitude.

14. Machine according to Claim 13, characterised in that at least one through-hole (82) is formed in the bottom of each seat (14) of the movable mask (13), and in that the transfer means include at least one pusher member (83) for each of the seats (14), the members being carried by the base structure (110) of the carriage (11) and extending into the through-holes in the bottoms of the respective seats (14) of the movable mask (13).

15. Machine according to any one of the preceding claims, characterised in that it further includes first position sensor means (200) for the movable mask (13), for enabling the activation of the sequencing means (7) only when the movable mask is in the loading position.

16. Machine according to Claim 15, characterised in that it further includes second position sensor means (201) for the movable mask, and stop means (202) in the path of the movable mask and actuable by the second position sensor means when the movable mask is in the withdrawn position to allow its movements to the loading position only after activation of the transfer means (83;100-104).

17. Machine according to any one of the preceding claims, characterised in that the fixed mask (8) constitutes part of a working module (300) which can be inserted in and removed from the machine and is operatively disposed in the machine beneath the sequencing means (7).

18. Machine according to Claim 17, characterised in that it further includes a discharge module (310) which can be inserted in the machine in place of a working module (300) and which carries a plurality of collecting containers (315) for receiving the components dropped by the sequencing means (7).

FIG. 1

# FIG. 2

FIG. 3

FIG. 4

# FIG. 5

# FIG. 6

FIG. 7

FIG. 8

10b

10b

10b

10b

10b

IX

8

9

C

13

12

14

11

81

80

200

2

8

13

0 225 957

FIG. 9

9    10b
8
11    13
99
90
89    83
12    14    110
2
91    83
90a    91a

FIG. 11

104
100
101    14
PBC
11    C
89    13
88
12    83
2    91
90a    90    91a

FIG. 10

FIG. 12

FIG. 13

FIG. 14

300
304
301a
301
302
302
303
6
10b
304
301a
303
305
10b
8
303
8a

310
304
311a
304
6
311
311a
313
314
312
315
313
313

0 225 957

## DOCUMENTS CONSIDERED TO BE RELEVANT

| Category | Citation of document with indication, where appropriate, of relevant passages | Relevant to claim | CLASSIFICATION OF THE APPLICATION (Int. Cl.4) |
|---|---|---|---|
| X | US-A-4 386 464 (TAIYO YUDEN) * Column 13, line 46 - column 14, line 16; figures 1-11 * | 1,6 | H 05 K 13/04 |
| A | US-A-4 451 324 (SONY) * Page 1, abstract; figures 1,2,6,12-14 * | 1 | |
| A | JOURNAL OF ELECTRONIC ENGINEERING, vol. 18, no. 170, February 1981, pages 73-76, Tokyo, JP; M. KUBO: "Cooperative efforts lead to innovation in automatic chip components mounting systems" * Page 74, left-hand column, paragraphs 1,2; figure 1; page 74, right-hand column, paragraph 1 * | 1,2 | |

**TECHNICAL FIELDS SEARCHED (Int. Cl.4)**

H 05 K

The present search report has been drawn up for all claims

| Place of search | Date of completion of the search | Examiner |
|---|---|---|
| THE HAGUE | 14-08-1986 | LOMMEL A. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO Form 1503 03 82